Europäisches Patentamt

European Patent Office

Office européen des brevets

(19)

(11) Veröffentlichungsnummer : **0 436 556 B1**

(12) **EUROPÄISCHE PATENTSCHRIFT**

(45) Veröffentlichungstag der Patentschrift :
10.03.93 Patentblatt 93/10

(51) Int. Cl.⁵ : **H03H 9/02**

(21) Anmeldenummer : **89909160.7**

(22) Anmeldetag : **23.08.89**

(86) Internationale Anmeldenummer :
**PCT/DE89/00553**

(87) Internationale Veröffentlichungsnummer :
**WO 90/03690 05.04.90 Gazette 90/08**

(54) **OBERFLÄCHENWELLENFILTER.**

(30) Priorität : **28.09.88 DE 3832943**

(43) Veröffentlichungstag der Anmeldung :
**17.07.91 Patentblatt 91/29**

(45) Bekanntmachung des Hinweises auf die
Patenterteilung :
**10.03.93 Patentblatt 93/10**

(84) Benannte Vertragsstaaten :
**AT BE CH DE FR GB IT LI LU NL SE**

(56) Entgegenhaltungen :
**US-A- 4 044 321**
**US-A- 4 468 642**
**Patent Abstracts of Japan, vol. No.318, (E-366)**
**(2041), 13 December 1985 & JP, A, 60150312**
**(TOSHIBA K.K.) 8 August 1985**

(73) Patentinhaber : **SIEMENS**
**AKTIENGESELLSCHAFT**
**Wittelsbacherplatz 2**
**W-8000 München 2 (DE)**

(72) Erfinder : **ANEMOGIANNIS, Kimon**
**Ravensburger Ring 18**
**W-8000 München 60 (DE)**

EP 0 436 556 B1

**Beschreibung**

Die vorliegende Erfindung bezieht sich auf ein Oberflächenwellenfilter gemäß dem Oberbegriff des Patentanspruches 1.

Das aus der US-A-4 468 642 bekannte Oberflächenwellenfilter ist ein Bandpaßfilter, dessen Übertragungscharakteristik geringe Verluste im Durchlaßbereich aufweist und das eine hohe Sperrdämpfung sowie hohe Flankensteilheit besitzt. Dieses bekannte Filter weist zwei Spuren mit je drei bzw. fünf bzw. noch mehr ungradzahlig vielen Interdigitalwandlern auf, wobei diese Spur die Wellenfortpflanzungsrichtung innerhalb dieser Anordnung der Wandler der jeweils einen Spur ist. Die jeweils zwei endständigen Interdigitalwandler einer jeden Spur haben zugeordnete Reflektor-Anordnungen, die dazu vorgesehen sind, die in Richtung weg von den Wandleranordnungen der Spur vom jeweils endständigen Wandler ausgesandten Oberflächenwellen derart zurück zu reflektieren, daß diese endständigen Wandler wie unidirektionale Wandler wirken. Zwischen jeweils zwei Wandlern einer Spur, z.B. Eingangswandlern der ersten Spur, ist ein Koppelwandler vorgesehen. Entsprechendes gilt für die zweite Spur, in der dann diese auf beiden Seiten des betreffenden Koppelwandlers der zweiten Spur angeordneten Wandler Ausgangswandler des ganzen Filters sind. Die Kopplung zwischen beiden Spuren ist durch elektrische Verbindung des jeweils einen busbars bzw. der jeweils einen Sammelschiene eines Koppelwandlers der ersten Spur und eines Koppelwandlers der zweiten Spur bewirkt. Für minimalen Verlust, d.h. für minimale Anpassungsdämpfung, ist es erforderlich, daß die zwei elektrisch miteinander verbundenen Koppelwandler der einen und der anderen Spur impedanzmäßig sehr genau aufeinander abgestimmt sind. Hierzu sind identische Koppellwandler erforderlich. In der Praxis tritt aber dennoch Fehlanpassung zu einem gewissen Maße auf, die u.a. auf noch nachfolgend beschriebenem Effekt beruht.

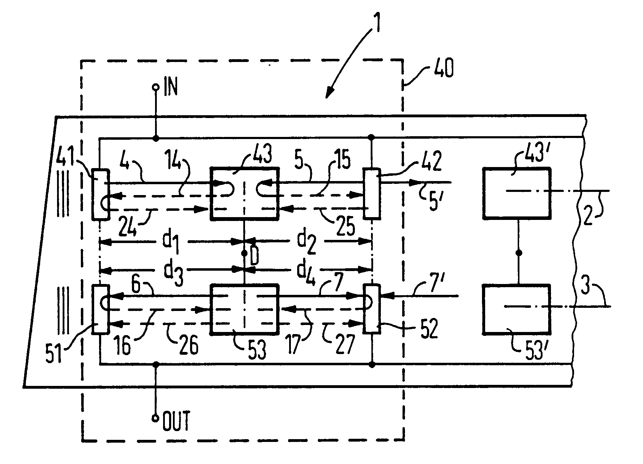

Bezüglich weiterer Einzelheiten und der Betriebsweise eines solchen voranstehend umrissenen bekannten Bandpaßfilters in Oberflächenwellentechnik sei auf die genannte US-A-4 468 642 hingewiesen. Die Figuren 1, 4 und 5 dieser Druckschrift zeigen Ausführungsformen und weitere Figuren geben Einzelheiten über die Übertragungscharakteristiken an.

Die hier beigefügte Figur zeigt eine einfachste Ausführungsform eines solchen bekannten Filters, dessen innerhalb der gestrichelten Abgrenzung enthaltenen Bestandteile eine Zelle dieses Filters bilden. Auch bei der Erfindung kann eine Aneinanderfügung solcher Zellen zu einer Ausführungsform nach Figur 5 der US-Patentschrift erweitert sein.

Die in der Figur angegebene Zelle 1 hat in der ersten Spur 2 zwei, z.B. als Filtereingang zu betreibende, elektrisch parallelgeschaltete Interdigitalwandler 41 und 42 und dazwischenliegend einen Koppelwandler 43. Von den Wandlern 41 und 42 angeregte und ausgehende akustische Wellen 4 und 5 sind parallel der Spur 2 auf den Koppelwandler 43 zu gerichtet. Im Koppelwandler 43 erzeugen diese akustische Wellen 4 und 5 ein elektrisches Signal, das am Schaltungspunkt D (gegen Masse) auftritt. Die Anregung durch die akustischen Wellen 4 und 5 ist derart, daß bei symmetrischem Koppelwandler 43 diese akustischen Wellen 4 und 5 mit gleicher Phase auf diesen Koppelwandler 43 treffen müssen. Bei einem antisymmetrischen Koppelwandler 43 muß dieses Auftreffen gegenphasig sein. Die Interdigitalwandler 41 und 42 sind symmetrische oder antisymmetrische Wandler, angeordnet in entsprechendem Abstand bezogen auf den Koppelwandler 43. Die Anordnung der Wandler 51, 52 und 53 der Spur 3 ist bezüglich der Phase sinngemäß die gleiche wie in der Spur 2. Sind die parallelgeschalteten Wandler 41 und 42 der Eingang des Filters, so sind die parallelgeschalteten Wandler 51 und 52 dessen Ausgang. Der Koppelwandler 53 wird vom Schaltungspunkt D ausgehend elektrisch angeregt und sendet Oberflächenwellen 6, 7 in Richtung auf die Wandler 51 und 52 aus. Ist der Koppelwandler 43 symmetrisch, so ist dies auch der Koppelwandler 53. Bei antisymmetrischem Koppelwandler 43 muß der Koppelwandler 53 ebenfalls antisymmetrisch sein. Beide Koppelwandler 43 und 53 sind identisch im Aufbau. Bei z.B. symmetrischen Wandlern 51, 52 und 53 läßt man die Wellen 6 und 7 mit gleicher Phase auf die Wandler 51 und 52 auftreffen, wozu die Abstände $d_3$, $d_4$ entsprechend gewählt sind. Bei einem antisymmetrischen Wandler sind $(2n - 1) \cdot \lambda/2$ angepaßte Abstände vorzusehen, worin $\lambda$ die Wellenlänge der akustischen Oberflächenwelle im Substrat ist. Diese Maßnahmen dienen der Anpassung.

Die Reflektoranordnungen 40 sind bereits oben beschrieben worden.

Ein solches Filter nach der Figur bzw. nach Art der US-A-4 468 642 zeigt in seiner Übertragungscharakteristik an sich nicht erwartete Störungen, die den Wert eines solchen Filters beeinträchtigen. Diese Störungen können als Fehlanpassungen bezeichnet werden, ohne daß damit deren Ursache genannt oder gar deren Beseitigungsmöglichkeit erkennbar gemacht wäre.

Aufgabe der vorliegenden Erfindung ist es, eine möglichst glatte, störungsfreie Übertragungscharakteristik eines wie voranstehend beschriebenen, in seiner Art aus der US-A-4 468 642 bekannten Bandpaß-Filters anzugeben.

Diese Aufgabe wird mit den Maßnahmen des Patentanspruches 1 gelöst.

Der vorliegenden Erfindung liegt die Erkenntnis zugrunde, daß die angesprochenen Störungen der Übertragungscharakteristik auf unerwünschten mechanischen und/oder elektrischen Reflexionen an den Fingerkanten der beteiligten Wandler beruhen.

Solche Reflexionen durch direkte Maßnahmen zu beseitigen, ist als unmöglich erkannt worden. Gewonnen wurde aber die Erkenntnis, daß in einem solchen Filter sog. Doppel-Transit-Signale auftreten, die solche Störungen bzw. Welligkeit der Übertragungscharakteristik, Ripples, verursachen.

Dieses Doppel-Transit-Signal darf nicht mit Trippel-Transit-Signalen verwechselt werden, die bekannterweise in Wandlern auftreten. Eine Zwei-Spur-Anordnung mit Maßnahmen zur Beseitigung solcher Trippel-Transit-Signale ist nämlich aus der JP-A-60-150312 bekannt.

Diese Anordnung bedingt im übrigen für ihren bestimmungsgemäßen Betrieb relativ aufwendige periphere Schaltungskomponenten (zum Beispiel die Differenzverstärker). Gegenüber der noch zu beschreibenden Erfindung haben dort die endständigen Wandler und die in der jeweiligen Spur liegenden Wandler andere Funktionen und die elektrische Kopplung zweier Wandler im Filter gibt es dort nicht.

Mit 14 und 15 sind Oberflächenwellen-Energieanteile in Figur 1 angedeutet, die auf Reflexionen einer Oberflächenwelle 4 bzw. Einer Oberflächenwelle 5 an bzw. in dem Koppelwandler 43 beruhen. An sich sind solche rücklaufenden Wellen 14, 15 lange bekannt und sie führen zu wiederum, jetzt an den Wandlern 41 und 42 rückreflektierten, rücklaufenden Wellen 24 und 25. Entsprechende reflektierte Wellen 16 bzw. 17 und 26 und 27 treten zwischen den Wandlern 51, 52 und 53 der Spur 3 auf, wobei der Wandler 53 der dem Koppelwandler 43 zugeordnete Koppelwandler ist.

Das Doppel-Transit-Signal hat in dem Filter 1 zwischen Eingang "IN" und Ausgang "OUT" die doppelte Gruppenlaufzeit, verglichen mit der einfachen Gruppenlaufzeit der Wellen der Wege 4+6; 4+7; 5+6 und 5+7, nämlich der akustischen Wegstrecke des Soll-Signals.

In bzw. an den Wandlern treten aber auch mechanische und/oder elektrische Reflexionen auf.

Doppel-Transit-Signale treten im Ausgang "OUT" des Filters aufgrund der Wellenfolgen bzw. Doppel-Transitwege zwischen Eingangs- und Ausgangswandler 4 + 14 + 24 + 6; 4 + 14 + 24 + 7; 5 + 15 + 25 + 6; 5 + 15 + 25 + 7 sowie auch der Wege 4 + 6 + 16 + 26; 4 + 7 + 17 + 27, 5 + 6 + 16 + 26 und 5 + 7 + 17 + 27 auf. Unabhängig davon treten Trippel-Transit-Signale auf, die hier nicht zu erörtern und z.B. durch bekannte Maßnahmen zu beseitigen sind.

In einem Filter nach Figur 1 treten aber außerdem noch 4-fach-Transit-Signale auf, wie z.B. der Wege 4 + 14 + 24 + 6 + 16 + 26; 4 + 14 + 24 + 7 + 17 + 27; usw.

Mit der Erfindung sind "ripples" erzeugende Doppel- und 2N-fach-Signale (mit N = natürliche Zahl) weitestgehend beseitigt.

Maßnahmen der Erfindung sind, die Abstände zwischen den Wandlern 41 und 43 (=d1), 42 und 43 (=d2), 53 und 51 (=d3) sowie 53 und 52 (=d4) unterschiedlich groß zu bemessen. Die Abstände d sind die Mittenabstände, d.h. die Abstände zwischen der wirksamen Mitte des einen und der wirksamen Mitte des jeweils anderen Wandlers.

Erfindungsgemäß gilt die Bemessung

$$d_1 - d_2 = n_1 . \lambda + k * \qquad (1)$$
$$d_3 - d_4 = n_2 . \lambda + k * * \qquad (2)$$
$$d_1 - d_3 = n_3 . \lambda \pm (2n' - 1) \cdot \lambda/4. \qquad (3)$$

Daraus folgt dann noch die Beziehung

$$d_2 - d_4 = n_4 . \lambda \pm (2 n'' - 1) \cdot \lambda/4. \qquad (4)$$

Bei Vorgabe der Gleichung (4) folgt die Gleichung (3).

Darin sind $d_1$ bis $d_4$ die oben angegebenen Mittenabstände der benachbarten Wandler voneinander. $n_1$, $n_2$, $n_3$, $n_4$ und $n'$, $n''$ sind natürliche Zahlen. $k*$ und $k'**$ sind Korrekturgrößen.

Zum Beispiel für ausschließlich symmetrische oder ausschließlich antisymmetrische Wandler 41, 42, 43, 51, 52, 53 gilt $k* = k** = 0$.

Es gibt aber auch Fälle, bei denen zusammen symmetrische und antisymmetrische Wandler vorkommen. Bezüglich $k*$ und $k**$ gilt dann, daß $k* = (2n* - 1) \cdot \lambda/2$ ($n* =$ natürliche Zahl) ist, wenn von den Wandlern 41, 42, 43 der Strecken $d_1$ und $d_2$ der Gleichung (1) ein Wandler antisymmetrisch und die übrigen symmetrisch oder wenn zwei Wandler antisymmetrisch und ein Wandler symmetrisch ist. Es ist $k** = (2n** - 1) \cdot \lambda/2$, wenn entsprechendes für die Wandler 51, 52, 53 der zweiten Spur, d.h. der Gleichung (2) gilt.

Mit den Korrekturfaktoren $k*$, $k**$ werden die ansonsten vorhandenen Phasenfehler bei symmetrisch/antisymmetrischer Paarung von Wandlern einer Strecke $d_1$, $d_2$, $d_3$, $d_4$ ausgeglichen.

Die Erfindung ergibt die vorgesehene Kompensation von Doppel-(2N-fach)-Transit-Signalen und damit die Beseitigung der darauf ansonsten beruhenden Ripples.

Das Erfindungsprinzip kann sinngemäß mit gleichem Erfolg auch bei einem Filter mit mehreren Koppelwandler-Paaren angewendet werden, wie es in der obengenannten US-PS z.B. in den Figuren 4, 5, 6, angegeben ist.

Bei einem erfindungsgemäß ausgeführten Beispiel eines $LiNbO_3$-YZ und eines $LiTaO_3$-36rotY-Filters für 450 MHz und 900 MHz sind die Störsignale im Vergleich zu den Angaben der US-PS um mindestens 20 dB unterdrückt und das Filter hat einen glatten Durchlaßbereich.

**Patentansprüche**

1. Oberflächenwellenfilter nach Art eines Low-Loss-Filters mit in zwei Spuren in, bezogen auf die Wellenlange $\lambda$ der Oberflächenwelle, gewahlten Abständen voneinander angeordneten Interdigitalwandlern und Koppelwandlern,

gekennzeichnet dadurch, daß die Differenzen der wirksamen Mittenabstände $d_1$, $d_2$, $d_3$, $d_4$, die zwischen einem jeden Koppelwandler (43; 53) und dem jeweiligen der ihm zugeordneten Interdigitalwandler (41, 42; 51, 52) bemessen sind:

$$d_1 - d_2 = n_1 . \lambda + k^* \quad (1)$$
$$d_3 - d_4 = n_2 . \lambda + k^{**} \quad (2)$$
$$d_1 - d_3 = n_3 . \lambda \pm (2n' - 1) \cdot \lambda/4 \quad (3)$$
$$d_2 - d_4 = n_4 . \lambda \pm (2n'' - 1) \cdot \lambda/4, \quad (4)$$

worin $n_1$, $n_2$, $n_3$, $n_4$, $n'$, $n''$ natürliche Zahlen sind und für die Korrekturgrößen $k^*$, $k^{**}$ gilt:
$k^* = 0$, wenn die Wandler (41, 42, 43) der Wegstrecken $d_1$, $d_2$ der Gleichung (1) symmetrische oder antisymmetrische Wandler sind und
$k^{**} = 0$, wenn die Wandler (51, 52, 53) der Wegstrecken $d_3$, $d_4$ der Gleichung (2) symmetrische oder antisymmetrische Wandler sind, bzw.
$k^* = (2n^* - 1) \cdot \lambda/2$ ($n^*$ = natürliche Zahl), wenn das Wandlerpaar (41, 43, bzw. 42, 43) der einen Wegstrecke $d_1$ bzw.
$d_2$ der Gleichung (1) aus einem symmetrischen und einem antisymmetrischen Wandler besteht und dazu das Wandlerpaar der anderen Wegstrecke $d_1$ bzw. $d_2$ Wandler der gleichen Symmetrieart sind und
$k^{**} = (2n^{**} - 1) \cdot \lambda/2$ ($n^{**}$ = natürliche Zahl),
wenn das Wandlerpaar (51, 53 bzw. 52, 53) der einen Wegstrecke $d_3$ bzw. $d_4$ der Gleichung (2) aus einem symmetrischen oder einem antisymmetrischen Wandler besteht und dazu das Wandlerpaar der anderen Wegstrecke $d_4$ bzw. $d_3$ Wandler der gleichen Symmetrieart sind.

## Claims

1. Surface acoustic wave filter of the type of a lowloss filter having interdigital transducers and coupling transducers disposed at selected distances, relative to the wavelength $\lambda$ of the surface acoustic wave, from one another in two tracks, characterised in that the differences of the effective centre-to-centre distances $d_1$, $d_2$, $d_3$, $d_4$, are dimensioned between each coupling transducer (43; 53) and the respective one of the interdigital transducers (41, 42; 51, 52) associated with it:

$$d_1 - d_2 = n_1 . \lambda + k^* \quad (1)$$
$$d_3 - d_4 = n_2 . \lambda + k^{**} \quad (2)$$
$$d_1 - d_3 = n_3 . \lambda \pm (2n' - 1) \cdot \lambda/4 \quad (3)$$
$$d_2 - d_4 = n_4 . \lambda \pm (2n'' - 1) \cdot \lambda/4, \quad (4)$$

where
$n_1$, $n_2$, $n_3$, $n_4$, $n'$, $n''$ are natural numbers and the following holds true for the correction quantities $k^*$, $k^{**}$:
$k^* = 0$ if the transducers (41, 42, 43) of path distances $d_1$, $d_2$ of equation (1) are symmetric or antisymmetric transducers and

$k^{**} = 0$ if the transducers (51, 52, 53) of path distances $d_3$, $d_4$ of equation (2) are symmetric or antisymmetric transducers, or
$k^* = (2n^* - 1) \cdot \lambda/2$ ($n^*$ = natural number) if the transducer pair (41, 43 and 42, 43, respectively) of one path distance $d_1$ or $d_2$ of equation (1) consists of a symmetric and an antisymmetric transducer and, in addition, the transducer pair of the other path distance $d_1$ and $d_2$, respectively, are transducers of the same type of symmetry, and
$k^{**} = (2n^{**} - 1) \cdot \lambda/2$ ($n^{**}$ = natural number), if the transducer pair (51, 53 and 52, 53, respectively) of one path distance $d_3$ and $d_4$, respectively, of equation (2) consists of a symmetric or an antisymmetric transducer and, in addition, the transducer pair of the other path distance $d_4$ and $d_3$, respectively, are transducers of the same type of symmetry.

## Revendications

1. Filtre à ondes de surface du type d'un filtre à faibles pertes, ayant un transducteur interdigité et un transducteur de couplage, positionnés sur deux pistes et espacés l'un de l'autre d'une distance sélectionnée par rapport à la longueur d'ondes $\lambda$ du filtre à ondes de surface, caractérisé en ce que les différences de parcours effectifs centre à centre $d_1$, $d_2$, $d_3$, $d_4$, entre un des transducteurs de couplage (43 ; 53) et respectivement le transducteur interdigité qui lui correspond (41, 42 ; 51, 52) sont tels que:

$$d_1 - d_2 = n_1 . \lambda + k^* \quad (1)$$
$$d_3 - d_4 = n_2 . \lambda + k^{**} \quad (2)$$
$$d_1 - d_3 = n_3 . \lambda \pm (2n' - 1) . \lambda/4 \quad (3)$$
$$d_2 - d_4 = n_4 . \lambda \pm (2n'' - 1) . \lambda/4 \quad (4)$$

où $n_1$, $n_2$, $n_3$, $n_4$, $n'$, $n''$ sont des entiers naturels, alors que pour les coefficients correctifs $k^*$, $k^{**}$ on a :
$k^* = 0$, si les transducteurs (41, 42, 43) des parcours $d_1$, $d_2$ de l'équation (1) sont des transducteurs symétriques ou anti symétriques et
$k^{**} = 0$, si les transducteurs (51, 52, 53) des parcours $d_3$, $d_4$ de l'équation (2) sont des transducteurs symétriques ou antisymétriques, ou
$k^* = (2n^* - 1) . \lambda/2$ ($n^*$ = entier naturel), si le couple de transducteurs (41, 43, ou 42, 43) d'un des parcours $d_1$ et $d_2$ de l'équation (1) est constitué d'un transducteur symétrique et d'un transducteur antisymétrique et, d'autre part, si le couple de transducteurs des autres parcours $d_1$ et $d_2$ est constitué de transducteurs de même type de symétrie et
$k^{**} = (2n^{**} - 1) . \lambda/2$ ($n^{**}$ = entier naturel),
si le couple de transducteurs (51, 53 ou 52, 53) d'un des parcours $d_3$ et $d_4$ de l'équation (2) est constitué d'un transducteur symétrique ou d'un transducteur antisymétrique et, d'autre part, si le couple de transducteurs des autres parcours $d_4$ et $d_3$ est constitué de transducteurs de même type de symétrie.